# EUROPEAN PATENT APPLICATION

(11) **EP 4 797 895 A1**
(43) Date of publication of application: **26.08.2026**
(21) Application number: 26158593.9
(22) Date of filing: 13.02.2026
(51) Int. Cl.: H05K 7/20

(54) **SYSTEMS AND METHODS FOR DUAL-SIDE POWER MODULE COOLING SYSTEM**

(30) Priority: 20.02.2025 US 202519058756
(71) Applicant: Borgwarner Inc., Auburn Hills, Michigan 48326 (US)
(72) Inventor: HOW, Jun Jie, Singapore (SG); CHONG, Yew Ming, Singapore (SG); ZHONG, Jianfang, Singapore (SG); CHIN, Raphael John Kexiang, Singapore (SG); ONG, Lay Boon, Singapore (SG)
(74) Representative: Office Freylinger

(57) **Abstract**

A system includes a power converter, wherein the power converter includes: a first power module; and a cooling module configured to extract heat from the first power module, wherein the cooling module includes: a first heatsink plate with a connector; and a second heatsink plate with an extruded connector, wherein the extruded connector of the second heatsink plate is laser welded to the connector of the first heatsink plate.

## Description

### TECHNICAL FIELD

Various embodiments of the present disclosure relate generally to a cooling system for a dual-side power module assembly, and more specifically, to systems and methods of welding heatsink plates of a cooling system for a power converter in an electric vehicle.

### BACKGROUND

Thermal management is considered a key technical aspect in an electric vehicle system. A cooling system may therefore be critical for a power converter, such as an inverter which controls the performance and efficiency of an overall driving system of an electric vehicle. However, some dual-side power modules may require seals and clamps to assemble upper and lower heatsinks to the power module(s), which may significantly increase the costs and complexity associated with the power converter.

The present disclosure is directed to overcoming one or more of these above referenced challenges.

### SUMMARY OF THE DISCLOSURE

In some aspects, the techniques described herein relate to a system including a power converter, wherein the power converter includes: a first power module; and a cooling module configured to extract heat from the first power module, wherein the cooling module includes: a first heatsink plate with a connector; and a second heatsink plate with an extruded connector, wherein the extruded connector of the second heatsink plate is laser welded to the connector of the first heatsink plate.

In some aspects, the techniques described herein relate to a system, the power converter further including: a second power module; a third power module; a fourth power module; a fifth power module; and a sixth power module, wherein the cooling module is configured to extract heat from the second power module, the third power module, the fourth power module, the fifth power module, and the sixth power module.

In some aspects, the techniques described herein relate to a system, wherein the first heatsink plate includes fins extending away from a surface of the first heatsink plate.

In some aspects, the techniques described herein relate to a system, wherein the extruded connector is formed by one or more of extrusion, die casting, or machining.

In some aspects, the techniques described herein relate to a system, wherein the laser weld is one or more of a lap joint weld or a butt joint weld.

In some aspects, the techniques described herein relate to a system, wherein an outer diameter of the extruded connector is smaller than an inner diameter of the connector.

In some aspects, the techniques described herein relate to a system, wherein an inner diameter of the extruded connector is the same as an inner diameter of the connector.

In some aspects, the techniques described herein relate to a system, wherein the extruded connector extends to the first heatsink plate such that an end surface of the extruded connector abuts a surface of the first heatsink plate.

In some aspects, the techniques described herein relate to a system, wherein the laser weld extends through the first heatsink plate and the end surface of the extruded connector.

In some aspects, the techniques described herein relate to a system, wherein the extruded connector is aligned with the connector.

In some aspects, the techniques described herein relate to a system, wherein the extruded connector extends through the connector such that an outer surface of a sidewall of the extruded connector abuts an inner surface of the connector.

In some aspects, the techniques described herein relate to a system, wherein the outer surface of the sidewall is laser welded to the inner surface of the connector.

In some aspects, the techniques described herein relate to a system, wherein an end surface of the extruded connector is planar with a surface of the first heatsink plate.

In some aspects, the techniques described herein relate to a system, wherein the connector of the first heatsink plate is extruded.

In some aspects, the techniques described herein relate to a system, wherein the extruded connector extends through the connector such that an outer surface of a sidewall of the extruded connector abuts an inner surface of a sidewall of the connector, and wherein an end surface of the extruded connector is planar with an end surface of the connector.

In some aspects, the techniques described herein relate to a system, wherein the cooling module does not include a gasket seal.

In some aspects, the techniques described herein relate to a cooling module including: a first heatsink plate including a first connector for a coolant; and a second heatsink plate including a first extruded connector for the coolant, wherein the first extruded connector of the second heatsink plate is laser welded to the first connector of the first heatsink plate.

In some aspects, the techniques described herein relate to a cooling module, wherein: the first heatsink plate further includes a second connector for the coolant, the second heatsink plate further includes a second extruded connector for the coolant, and the second extruded connector of the second heatsink plate is laser welded to the second connector of the first heatsink plate.

In some aspects, the techniques described herein relate to a cooling module, wherein the first extruded connector of the second heatsink plate is laser welded to the first connector of the first heatsink plate by one or more of a butt joint laser weld, top lap joint laser weld, side lap joint laser weld, flush edge joint laser weld, recessed edge joint laser weld, or protruding edge joint laser weld.

In some aspects, the techniques described herein relate to a method including: laser welding a first connector of a first heatsink plate to a first connector of a second heatsink plate, wherein the first connector of the first heatsink plate and the first connector of the second heatsink plate are configured to transfer coolant from a first coolant chamber to a second coolant chamber.

Additional objects and advantages of the disclosed embodiments will be set forth in part in the description that follows, and in part will be apparent from the description, or may be learned by practice of the disclosed embodiments. The objects and advantages of the disclosed embodiments will be realized and attained by means of the elements and combinations particularly pointed out in the appended claims.

It is to be understood that both the foregoing general description and the following detailed description are exemplary and explanatory only and are not restrictive of the disclosed embodiments, as claimed.

### BRIEF DESCRIPTION OF THE DRAWINGS

The accompanying drawings, which are incorporated in and constitute a part of this specification, illustrate various exemplary embodiments and together with the description, serve to explain the principles of the disclosed embodiments.
FIG. 1 depicts an exemplary system infrastructure for a vehicle including a power converter, according to one or more embodiments.
FIG. 2A depicts an exemplary power module assembly, according to one or more embodiments.
FIG. 2B depicts an exploded view of a power module assembly, according to one or more embodiments.
FIG. 3A depicts an exemplary view of a plurality of power modules assembled to a heatsink plate, according to one or more embodiments.
FIG. 3B depicts an exemplary heatsink plate, according to one or more embodiments.
FIG. 3C depicts an exemplary extruded connector in a heatsink plate, according to one or more embodiments.
FIG. 4A depicts an exemplary heatsink plate with an extruded connector, according to one or more embodiments.
FIG. 4B depicts an exemplary heatsink plate without an extruded connector, according to one or more embodiments.
FIG. 4C depicts an exemplary heatsink plate with fins, according to one or more embodiments.
FIG. 5A depicts an exemplary extruded connector of a first heatsink plate welded to an extruded connector of a second heatsink plate, according to one or more embodiments.
FIG. 5B depicts an exemplary continuous weld seam pattern, according to one or more embodiments.
FIG. 6A depicts an exemplary butt joint weld with an extruded connector, according to one or more embodiments.
FIG. 6B depicts an exemplary top lap joint weld with an extruded connector, according to one or more embodiments.
FIG. 6C depicts an exemplary side lap joint weld with an extruded connector, according to one or more embodiments.
FIG. 6D depicts an exemplary flush edge joint weld with an extruded connector, according to one or more embodiments.
FIG. 6E depicts an exemplary recessed edge joint weld with an extruded connector, according to one or more embodiments.
FIG. 6F depicts an exemplary protruding edge joint weld with an extruded connector, according to one or more embodiments.
FIG. 7 depicts an exemplary housing assembly with a power module assembly, according to one or more embodiments.

### DETAILED DESCRIPTION OF EMBODIMENTS

Both the foregoing general description and the following detailed description are exemplary and explanatory only and are not restrictive of the features, as claimed. As used herein, the terms "comprises," "comprising," "has," "having," "includes," "including," or other variations thereof, are intended to cover a non-exclusive inclusion such that a process, method, article, or apparatus that comprises a list of elements does not include only those elements, but may include other elements not expressly listed or inherent to such a process, method, article, or apparatus. In this disclosure, unless stated otherwise, relative terms, such as, for example, "about," "substantially," and "approximately" are used to indicate a possible variation of ±10% in the stated value. In this disclosure, unless stated otherwise, any numeric value may include a possible variation of ±10% in the stated value.

The terminology used below may be interpreted in its broadest reasonable manner, even though it is being used in conjunction with a detailed description of certain specific examples of the present disclosure. Indeed, certain terms may even be emphasized below; however, any terminology intended to be interpreted in any restricted manner will be overtly and specifically defined as such in this Detailed Description section. For example, in the context of the disclosure, the power module may be described as a device, but may refer to any device for controlling the flow of power in an electrical circuit. For example, a power module may be a metal-oxide-semiconductor field-effect transistor (MOSFETs), bipolar junction transistor (BJTs), insulated-gate bipolar transistor (IGBTs), or relays, for example, or any combination thereof, but are not limited thereto.

Various embodiments of the present disclosure relate generally to a cooling system for a dual-side power module assembly, and more specifically, to systems and methods of welding heatsink plates of a cooling system for a power converter in an electric vehicle.

Thermal management may be considered a key technical aspect in an electric vehicle system. The interaction between a cooling system and a power module may therefore be critical in a power conversion unit, such as a traction inverter system, which controls the performance and efficiency of an overall driving system of an electric vehicle. Some dual-side power module assemblies include a rubber seal between the upper heatsink plate and the lower heatsink plate. Balancing sufficient rubber compression from the rubber seal without causing undesired stress on the power module(s) is difficult due to high tolerance stack-up issues. Additionally, using a rubber seal at a coolant path for a cooling system may cause the cooling system to leak due to rubber degradation, compression set over time, and/or corrosion.

Some dual-side power module assemblies may also include numerous spring clamps to keep the module securely in place. The spring clamps in combination with the rubber seal create a bowing effect that causes excessive stress on the power module(s), potentially leading to cracks and/or failure. The additional components needed to keep the assembly sealed together (e.g., the rubber seals and the spring clamps) also increase the cost and complexity associated with the assembly. Thus, there is a need for a dual-side power module assembly that has fewer parts and is less costly than some assemblies.

One or more embodiments may include a first heatsink plate with an extruded connector and a second heatsink plate with an extruded connector for a dual-side power module cooling system. One or more embodiments may include a first heatsink plate with a non-extruded connector and a second heatsink plate with an extruded connector for a dual-side power module cooling system. One or more embodiments may include laser welding between the first heatsink plate and the second heatsink plate. One or more embodiments may include a butt joint weld between the first heatsink plate connector and the second heatsink plate extruded connector. One or more embodiments may include a butt joint weld between the first heatsink plate extruded connector and the second heatsink plate extruded connector. One or more embodiments may include a lap joint weld between the first heatsink plate connector and the second heatsink plate extruded connector. One or more embodiments may include a lap joint weld between the first heatsink plate extruded connector and the second heatsink plate extruded connector. One or more embodiments may include an edge joint weld between the first heatsink plate extruded connector and the second heatsink plate extruded connector. One or more embodiments may include a housing sealed to the first heatsink plate to form a first cooling channel and a second cooling channel.

One or more embodiments may solve the problems of higher costs and extra parts with a dual-side power module assembly that includes laser welding to seal the dual-side cooling system to the power module(s). The dual-side power module assembly may use the housing (e.g., power converter housing) the assembly is assembled to as part of the dual-side cooling path by integrating heatsink fins. One or more embodiments may include a power module assembly that is sealed to a housing of the power converter for a dual-side cooling path. One or more embodiments may use laser welding to seal the interface between the cooling system and the power module(s) to reduce the uneven pressure exerted on the power module(s) due to the rubber seal and spring clamps. Laser welding the interface may reduce the heatsink bowing effect and the associated stress on the power module(s). One or more embodiments may simplify the design and manufacturing process for dual-side power module assemblies by using laser welding to couple a first (e.g., lower) heatsink plate to a second (e.g., upper) heatsink plate. At least one heatsink plate of the dual-side power module assembly may include an extruded connector (e.g., opening) at each end to facilitate the laser welding.

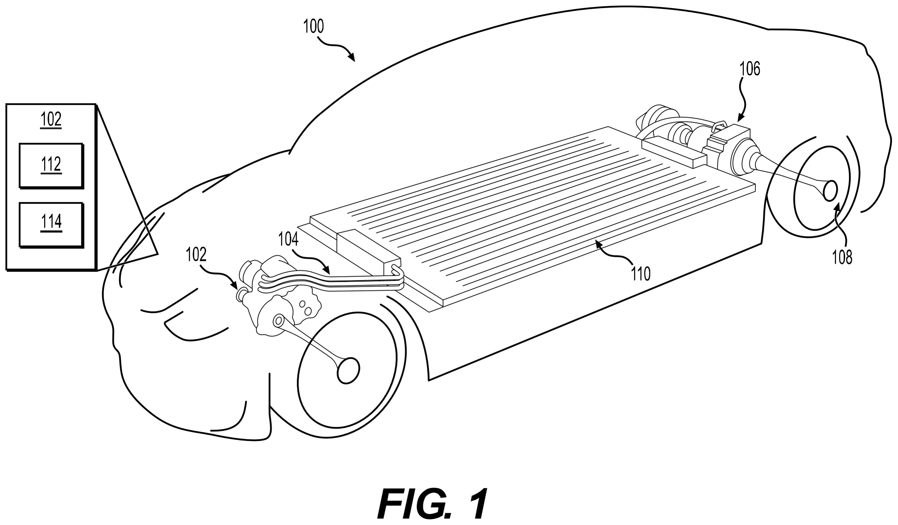

FIG. 1 depicts an exemplary system infrastructure for a vehicle including a power converter, according to one or more embodiments. Electric vehicle 100 may include power converter (e.g., a traction inverter) 102, electrical connectors 104, drive motor 106, wheels 108, and battery 110. Power converter 102 may include power module 112 and cooling module (e.g., a heatsink system) 114. Cooling module 114 may be used to cool (extract heat from) power module 112. Electrical connectors 104 may connect the power converter 102 and battery 110. Power converter 102 may include components to receive electrical power from an external source and output electrical power to charge battery 110 of electric vehicle 100. Power converter 102, through the use of a power module 112, may convert DC power from battery 110 in electric vehicle 100 to AC power, to rotate the drive motor 106 and wheels 108 of electric vehicle 100, for example, but the embodiments are not limited thereto. Power converter 102 may include more than one power module 112. The power converter 102 may be bidirectional, and may convert DC power to AC power, or convert AC power to DC power, such as during regenerative braking, for example. Power converter 102 may be a single-phase inverter, or a multi-phase inverter, such as a three-phase inverter, for example.

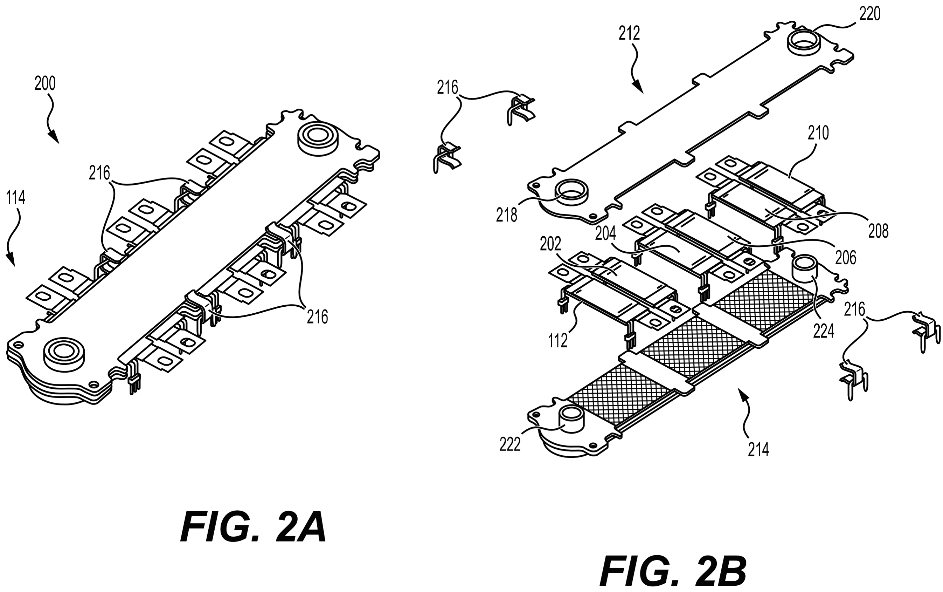

FIG. 2A depicts an exemplary power module assembly, according to one or more embodiments. Power module assembly 200 may include a cooling module 114 and one or more power modules, such as power module 112, power module 202, power module 204, power module 206, power module 208, and power module 210 as seen in FIG. 2B, which is an exploded view of a power module assembly. It should be appreciated that power module assembly 200 may have more or less than six power modules, but may include six. Cooling module 114 may include a first (e.g., lower) heatsink plate 212 and a second (e.g., upper) heatsink plate 214. Power modules 112, 202, 204, 206, 208, and 210 may be provided between first heatsink plate 212 and second heatsink plate 214. Power module assembly 200 may further include one or more clips 216. One or more clips 216 may provide a clamping force in a center section, for example, of first heatsink plate 212, power modules 112, 202, 204, 206, 208, 210, and second heatsink plate 214.

First heatsink plate 212 may include a first extruded connector 218 at a first end of first heatsink plate 212 and a second extruded connector 220 at a second end of first heatsink plate 212. Second heatsink plate 214 may include a first extruded connector 222 that corresponds with first extruded connector 218 of first heatsink plate 212 at a first end of second heatsink plate 214 and a second extruded connector 224 that corresponds with second extruded connector 220 of first heatsink plate 212 at a second end of second heatsink plate 214. When assembled, an outer surface of first extruded connector 222 of second heatsink plate 214 may be in contact with an inner surface of first extruded connector 218 of first heatsink plate 212 and second extruded connector 224 of second heatsink plate 214 may be in contact with an inner surface of second extruded connector 220 of first heatsink plate 212. Because the embodiments described herein use welding (e.g., laser welding) to couple first heatsink plate 212 with second heatsink plate 214, no rubber gasket seal is necessary. Thus, embodiments of the cooling module described herein do not include a gasket seal, a bushing, or spring clamps. Further, the extruded connectors described herein may be manufactured by extrusion, die casting, machining, and/or other known manufacturing processes.

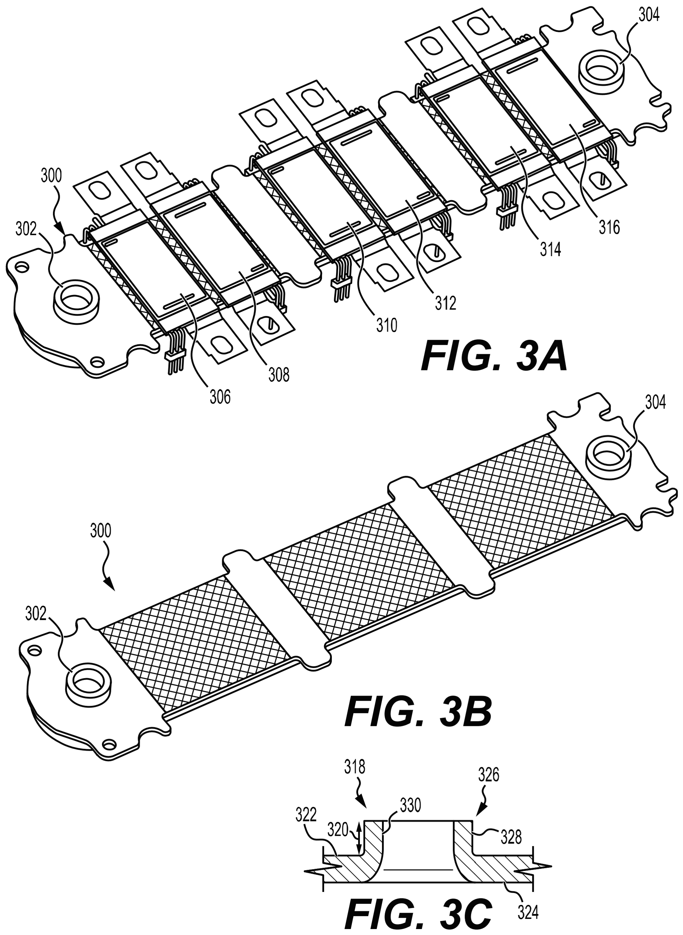

FIG. 3A depicts an exemplary view of a plurality of power modules assembled to a heatsink plate, according to one or more embodiments. Heatsink plate 300 may be substantially similar to second heatsink plate 214. For example, heatsink plate 300 may include a first extruded connector 302 at a first end and a second extruded connector 304 at a second end. One or more power modules, such as power module 306, power module 308, power module 310, power module 312, power module 314, and power module 316 may be coupled to heatsink plate 300. That is, power modules 306, 308, 310, 312, 314, and 316 may be mounted onto heatsink plate 300 with a thermal interface material (TIM) between the power modules 306, 308, 310, 312, 314, and 316 and the heatsink plate 300. FIG. 3B illustrates heatsink plate 300 without power modules 306, 308, 310, 312, 314, and 316.

FIG. 3C depicts an exemplary extruded connector in a heatsink plate, according to one or more embodiments. Extruded connector 318 may extend a distance 320 away from and substantially perpendicular to a surface 322 of a heatsink plate (e.g., heatsink plate 300). Extruded connector 318 may have rounded exterior edges (e.g., chamfered) with surface 322 and rounded interior edges (e.g., chamfered) with a surface 324 of the heatsink plate. A sidewall 326 of extruded connector 318 may include an outer surface 328 and an inner surface 330, the inner surface 330 defining a perimeter of the extruded connector 318.

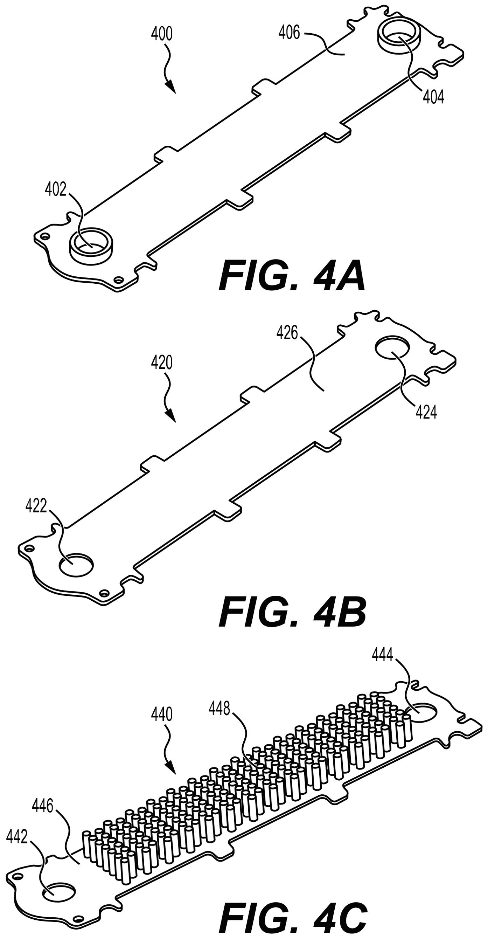

FIG. 4A depicts an exemplary heatsink plate with an extruded connector, according to one or more embodiments. Heatsink plate 400 may be substantially similar to first heatsink plate 212. For example, heatsink plate 400 may include a first extruded connector 402 at a first end and a second extruded connector 404 at a second end. First extruded connector 402 and second extruded connector 404 may extend a distance away from a surface 406 of heatsink plate 400. The first extruded connector 402 of heatsink plate 400 may facilitate better coupling to a corresponding first extruded connector of a second heatsink plate (e.g., second heatsink plate 214), and second extruded connector 404 of heatsink plate 400 may facilitate better coupling to a corresponding second extruded connector of the second heatsink plate (e.g., second heatsink plate 214). That is, the extra surface area from the extrusion of first extruded connector 402 and second extruded connector 404 may provide more contact area between heatsink plate 400 and a second heatsink plate (e.g., second heatsink plate 214).

FIG. 4B depicts an exemplary heatsink plate without an extruded connector, according to one or more embodiments. Heatsink plate 420 may be similar to heatsink plate 400. However, the connectors of heatsink plate 420 are not extruded. Rather, heatsink plate 420 may include a first connector 422 at a first end and a second connector 424 at a second end. First connector 422 and second connector 424 may be flush with a surface 426 of heatsink plate 420 instead of extending away from surface 426. First connector 422 and second connector 424 are connectors in heatsink plate 420 without any extrusion.

FIG. 4C depicts an exemplary heatsink plate with fins, according to one or more embodiments. Heatsink plate 440 may be similar to heatsink plate 420. Heatsink plate 440 may include a first connector 442 at a first end and a second connector 444 at a second end. First connector 442 and second connector 444 may be flush with a surface 446 of heatsink plate 440 instead of extending away from surface 446. First connector 442 and second connector 444 may be connectors in heatsink plate 440 without any extrusion. Heatsink plate 440 may include fins 448. Fins 448 may extend away from surface 446. Fins 448 may be cold forged with heatsink plate 440.

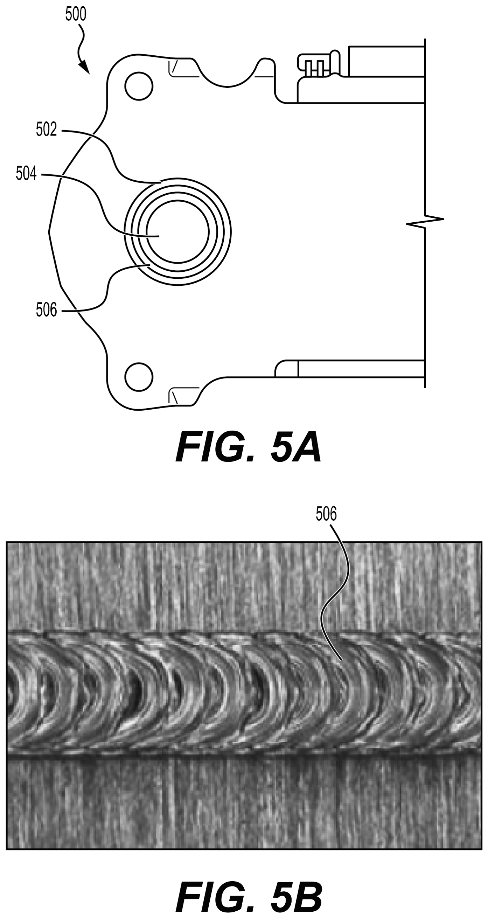

FIG. 5A depicts an exemplary extruded connector of a first heatsink plate welded to an extruded connector of a second heatsink plate, according to one or more embodiments. Heatsink plate 500 may include an extruded connector 502. Extruded connector 502 may circumferentially surround an extruded connector 504 from a second heatsink plate. Extruded connector 502 may contact and couple to extruded connector 504 via a weld 506. FIG. 5B depicts an exemplary continuous weld seam pattern, according to one or more embodiments. The weld seam pattern used in embodiments herein may be continuous and robust.

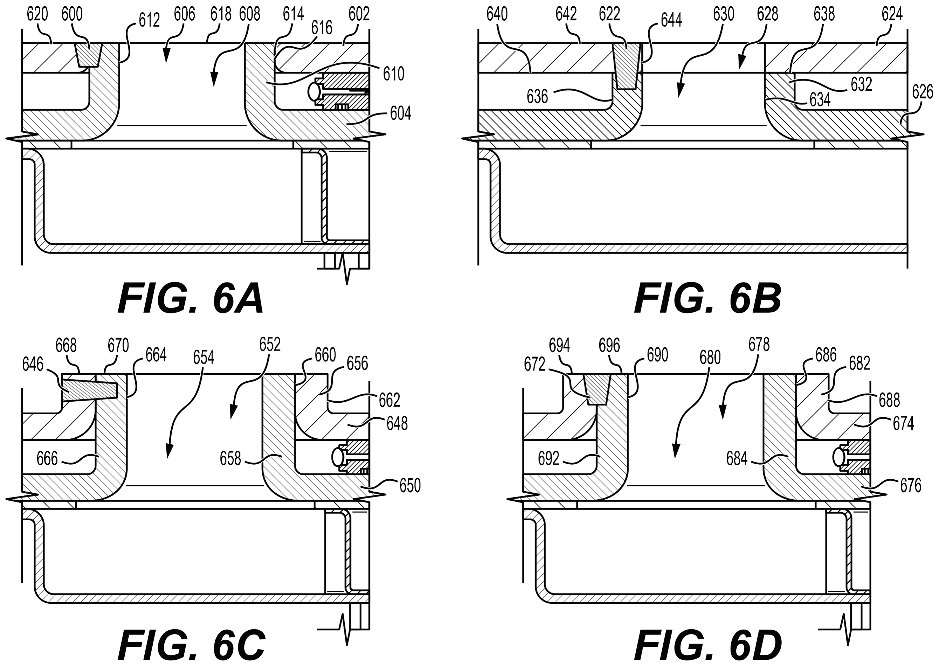

FIG. 6A depicts an exemplary butt joint weld with an extruded connector, according to one or more embodiments. A first heatsink plate 602 may be connected to a second heatsink plate 604 via a weld 600. First heatsink plate 602 may be substantially similar to heatsink plate 420 while second heatsink plate 604 may be substantially similar to second heatsink plate 214. Weld 600 may be a butt joint weld. Specifically, weld 600 may weld connector 606 of first heatsink plate 602 to an extruded connector 608 of second heatsink plate 604. Connector 606 of first heatsink plate 602 is not extruded. Extruded connector 608 may extend perpendicularly away from second heatsink plate 604 towards first heatsink plate 602. Extruded connector 608 may include a sidewall 610. An inner surface 612 of sidewall 610 may surround a perimeter of the cavity portion of extruded connector 608 while an outer surface 614 of sidewall 610 may contact an inner surface 616 of first heatsink plate 602. Thus, weld 600 may primarily weld outer surface 614 and inner surface 616 together.

A surface 618 at the end of extruded connector 608 may terminate within the same plane as a surface 620 of first heatsink plate 602. In other words, extruded connector 608 may be flush with surface 620. Extruded connector 608 therefore extends through first heatsink plate 602 but ends at surface 620. Extruded connector 608 may be extruded to allow enough space between first heatsink plate 602 and second heatsink plate 604 for one or more power modules. The one or more power modules may contact both first heatsink plate 602 and second heatsink plate 604, and be "sandwiched" between the two heatsinks. Weld 600 may circumferentially surround connector 606 and extruded connector 608. Weld 600 may extend from surface 620 into first heatsink plate 602 to weld first heatsink plate 602 (e.g., inner surface 616 and the surrounding area) to extruded connector 608 (e.g., outer surface 614 of sidewall 610).

FIG. 6B depicts an exemplary top lap joint weld with an extruded connector, according to one or more embodiments. A first heatsink plate 624 may be connected to a second heatsink plate 626 via a weld 622. First heatsink plate 624 may be substantially similar to heatsink plate 420 while second heatsink plate 626 may be substantially similar to second heatsink plate 214. Weld 622 may be a lap joint weld. Specifically, weld 622 may weld connector 628 of first heatsink plate 624 to an extruded connector 630 of second heatsink plate 626. Connector 628 of first heatsink plate 624 is not extruded. Extruded connector 630 may extend perpendicularly away from first heatsink plate 624 towards second heatsink plate 626. Extruded connector 630 may include a sidewall 632. Sidewall 632 may include an inner surface 634 that surrounds a perimeter of the cavity portion of extruded connector 630 and an outer surface 636.

A surface 638 at the end of extruded connector 630 may abut and contact a surface 640 of first heatsink plate 624. Thus, weld 622 may be formed by welding through first heatsink plate 624 (e.g., from a surface 642 to surface 640) and partially through extruded connector 630 of second heatsink plate 626. Specifically, surface 638 and a portion of sidewall 632 may be welded to first heatsink plate 624 via surface 640. Extruded connector 630 may be aligned with connector 628 such that inner surface 634 and an inner surface 644 of first heatsink plate 624 may be flush. After welding, the combination of inner surface 644 and inner surface 634 may create a flat, continuous surface from second heatsink plate 626 to first heatsink plate 624 within extruded connector 630 and connector 628. A diameter of extruded connector 630 may be equal to connector 628. Extruded connector 630 may be extruded to allow enough space between first heatsink plate 624 and second heatsink plate 626 for one or more power modules. The one or more power modules may contact both first heatsink plate 624 and second heatsink plate 626, and be "sandwiched" between the two heatsinks. Weld 622 may circumferentially surround connector 628 and extruded connector 630.

FIG. 6C depicts an exemplary side lap joint weld with an extruded connector, according to one or more embodiments. A first heatsink plate 648 may be connected to a second heatsink plate 650 via a weld 646. First heatsink plate 648 may be substantially similar to heatsink plate 400 while second heatsink plate 650 may be substantially similar to second heatsink plate 214. Weld 646 may be a lap joint weld. Specifically, weld 646 may weld an extruded connector 652 of first heatsink plate 648 to an extruded connector 654 of second heatsink plate 650. Extruded connector 652 may extend perpendicularly away from first heatsink plate 648 and second heatsink plate 650, and extruded connector 654 may extend perpendicularly away from second heatsink plate 650 towards first heatsink plate 648. Extruded connector 652 may include a sidewall 656 and extruded connector 654 may include a sidewall 658. An inner surface 660 of sidewall 656 may surround a perimeter of the cavity portion of extruded connector 652 while an outer surface 662 of sidewall 656 defines a perimeter of sidewall 656. Similarly, sidewall 658 may include an inner surface 664 that surrounds a perimeter of the cavity portion of extruded connector 654 and an outer surface 666. Extruded connector 654 may have a smaller diameter than extruded connector 652. Specifically, extruded connector 654 may be disposed within extruded connector 652 such that outer surface 666 abuts and contacts inner surface 660. Thus, weld 646 may primarily weld inner surface 660 and outer surface 666 together.

A surface 668 at the end of extruded connector 652 may terminate within the same plane as a surface 670 at the end of extruded connector 654. In other words, extruded connector 652 may be flush with extruded connector 654. Extruded connector 654 therefore extends through first heatsink plate 648 and extruded connector 652 but ends at surface 668. Weld 646 may be formed by welding through sidewall 656 and into a portion of sidewall 658 to weld first heatsink plate 648 to second heatsink plate 650 (e.g., extruded connector 652 to extruded connector 654). Specifically, weld 646 may extend from outer surface 662 into sidewall 658, welding through outer surface 666 but stopping prior to inner surface 664. Weld 646 may circumferentially surround extruded connector 652 and extruded connector 654. Extruded connector 654 may be extruded to allow enough space between first heatsink plate 648 and second heatsink plate 650 for one or more power modules. The one or more power modules may contact both first heatsink plate 648 and second heatsink plate 650, and be "sandwiched" between the two heatsinks.

FIG. 6D depicts an exemplary flush edge joint weld with an extruded connector, according to one or more embodiments. A first heatsink plate 674 may be connected to a second heatsink plate 676 via a weld 672. First heatsink plate 674 may be substantially similar to heatsink plate 400 while second heatsink plate 676 may be substantially similar to second heatsink plate 214. Weld 672, first heatsink plate 674, and second heatsink plate 676 may be substantially similar to weld 600, first heatsink plate 602, and second heatsink plate 604 except first heatsink plate 674 includes an extruded connector 678 (e.g., similar to extruded connector 652) instead of a flat connector such as connector 606. Weld 672 may be an edge joint weld. Specifically, weld 672 may weld extruded connector 678 to an extruded connector 680 of second heatsink plate 676. Extruded connector 678 may extend perpendicularly away from first heatsink plate 674 and second heatsink plate 676, and extruded connector 680 may extend perpendicularly away from second heatsink plate 676 towards first heatsink plate 674. Extruded connector 678 may include a sidewall 682 and extruded connector 680 may include a sidewall 684.

An inner surface 686 of sidewall 682 may surround a perimeter of the cavity portion of extruded connector 678 while an outer surface 688 of sidewall 682 defines a perimeter of sidewall 682. Similarly, sidewall 684 may include an inner surface 690 that surrounds a perimeter of the cavity portion of extruded connector 680 and an outer surface 692. Extruded connector 680 may have a smaller diameter than extruded connector 678. Specifically, extruded connector 680 may be disposed within extruded connector 678 such that outer surface 692 abuts and contacts inner surface 686. Thus, weld 672 may primarily weld inner surface 660 and outer surface 666 together. A top surface 694 of extruded connector 678 may be welded to a top surface 696 of extruded connector 680 as well.

Top surface 694 at the end of extruded connector 678 may terminate within the same plane as top surface 696 at the end of extruded connector 680. In other words, extruded connector 678 may be flush with extruded connector 680. Extruded connector 680 therefore extends through first heatsink plate 674 and extruded connector 678 but ends at top surface 694. Weld 672 may be formed by welding inner surface 686 to outer surface 692. Weld 672 may form a weld from top surface 694 and top surface 696 into a portion of sidewall 682 of extruded connector 678 and sidewall 684 of extruded connector 680. Weld 672 may circumferentially surround extruded connector 678 and extruded connector 680. Extruded connector 680 may be extruded to allow enough space between first heatsink plate 674 and second heatsink plate 676 for one or more power modules. The one or more power modules may contact both first heatsink plate 674 and second heatsink plate 676, and be "sandwiched" between the two heatsinks.

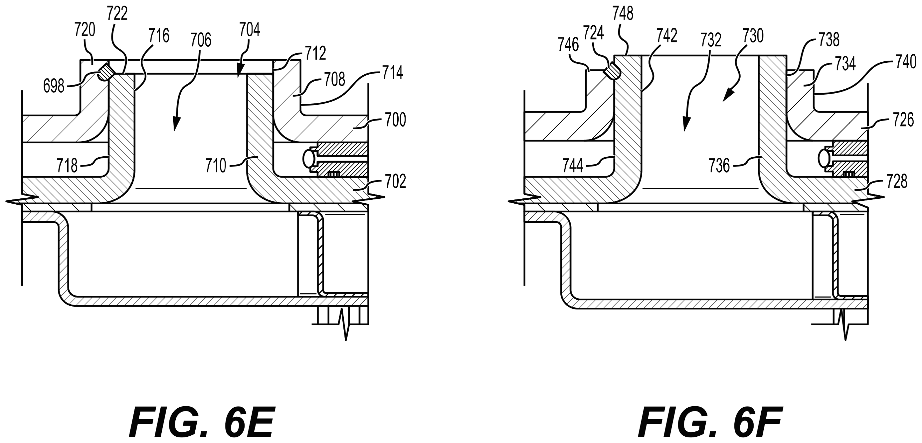

FIG. 6E depicts an exemplary recessed edge joint weld with an extruded connector, according to one or more embodiments. A first heatsink plate 700 may be connected to a second heatsink plate 702 via a weld 698. First heatsink plate 700 may be substantially similar to heatsink plate 400 while second heatsink plate 702 may be substantially similar to second heatsink plate 214. Weld 698 may be a recessed edge joint weld. Specifically, weld 698 may weld an extruded connector 704 of first heatsink plate 700 to an extruded connector 706 of second heatsink plate 702. Extruded connector 704 may extend perpendicularly away from first heatsink plate 700 and second heatsink plate 702, and extruded connector 706 may extend perpendicularly away from second heatsink plate 702 towards first heatsink plate 700. Extruded connector 704 may include a sidewall 708 and extruded connector 706 may include a sidewall 710. An inner surface 712 of sidewall 708 may surround a perimeter of the cavity portion of extruded connector 704 while an outer surface 714 of sidewall 708 defines a perimeter of sidewall 708. Similarly, sidewall 710 may include an inner surface 716 that surrounds a perimeter of the cavity portion of extruded connector 706 and an outer surface 718. Extruded connector 706 may have a smaller diameter than extruded connector 704. Specifically, extruded connector 706 may be disposed within extruded connector 704 such that outer surface 718 abuts and contacts inner surface 712.

A surface 720 at the end of extruded connector 704 may terminate above a surface 722 at the end of extruded connector 706. In other words, extruded connector 706 does not extend fully through extruded connector 704 and instead terminates within extruded connector 704 between the base of first heatsink plate 700 (e.g., the flat portion of first heatsink plate 700 not extruded to create extruded connector 704) and surface 720. An end portion of inner surface 712 near surface 720 is not in contact with outer surface 718, as the end portion extends past surface 722. Surface 720 is not planar with surface 722. Surface 720 may extend in and define a first plane while surface 722 may extend in and define a second plane that is parallel to and spaced apart from the first plane. The first plane in which surface 720 extends within does not intersect any portion of extruded connector 706, while the second plane in which surface 722 extends within intersects extruded connector 704 below surface 720.

Weld 698 may be formed by welding inner surface 712 to an edge of sidewall 710 at the end of extruded connector 706. Thus, a portion of surface 722 and a portion of outer surface 718 may be welded to a portion of inner surface 712 at weld 698. Weld 698 may continuously extend around extruded connector 704 and extruded connector 706. Extruded connector 706 may be extruded to allow enough space between first heatsink plate 700 and second heatsink plate 702 for one or more power modules. The one or more power modules may contact both first heatsink plate 700 and second heatsink plate 702, and be "sandwiched" between the two heatsinks.

FIG. 6F depicts an exemplary protruding edge joint weld with an extruded connector, according to one or more embodiments. A first heatsink plate 726 may be connected to a second heatsink plate 728 via a weld 724. First heatsink plate 726 may be substantially similar to heatsink plate 400 while second heatsink plate 728 may be substantially similar to second heatsink plate 214. Weld 724 may be a protruding edge joint weld. Specifically, weld 724 may weld an extruded connector 730 of first heatsink plate 726 to an extruded connector 732 of second heatsink plate 728. Extruded connector 730 may extend perpendicularly away from first heatsink plate 726 and second heatsink plate 728, and extruded connector 732 may extend perpendicularly away from second heatsink plate 728 towards first heatsink plate 726. Extruded connector 730 may include a sidewall 734 and extruded connector 732 may include a sidewall 736. An inner surface 738 of sidewall 734 may surround a perimeter of the cavity portion of extruded connector 730 while an outer surface 740 of sidewall 734 defines a perimeter of sidewall 734. Similarly, sidewall 736 may include an inner surface 742 that surrounds a perimeter of the cavity portion of extruded connector 732 and an outer surface 744. Extruded connector 732 may have a smaller diameter than extruded connector 730. Specifically, extruded connector 732 may be disposed within extruded connector 730 such that outer surface 744 abuts and contacts inner surface 738.

A surface 746 at the end of extruded connector 730 may terminate below a surface 748 at the end of extruded connector 732. In other words, extruded connector 732 extends fully through and past extruded connector 730 and does not terminate within extruded connector 730. An end portion of outer surface 744 near surface 748 is not in contact with inner surface 738 (or extruded connector 730 in general), as the end portion extends past surface 746. Surface 746 is not planar with surface 748. Surface 746 may extend in and define a first plane while surface 748 may extend in and define a second plane that is parallel to and spaced apart from the first plane. The first plane in which surface 746 extends within intersects a portion of extruded connector 732 below surface 748, while no portion of the second plane in which surface 748 extends within intersects extruded connector 730.

Weld 724 may be formed by welding outer surface 744 to an edge of sidewall 734 at the end of extruded connector 730. Thus, a portion of surface 746 and a portion of inner surface 738 may be welded to a portion of outer surface 744 at weld 724. Weld 724 may continuously extend around extruded connector 730 and extruded connector 732. Extruded connector 732 may be extruded to allow enough space between first heatsink plate 726 and second heatsink plate 728 for one or more power modules. The one or more power modules may contact both first heatsink plate 726 and second heatsink plate 728, and be "sandwiched" between the two heatsinks.

It should be appreciated that the extruded connectors described herein may be made using numerous different methods. Extruded connectors may be extruded or cast. Generally, each extruded connector may be a sleeve configured to provide a specific shape and surface to enable the laser weld connection. It should be appreciated the embodiments depicted and described with respect to FIGS. 6A-6F may only show one end of a cooling module and the heatsink plates described may, therefore, each include a second connector laser welded to each other.

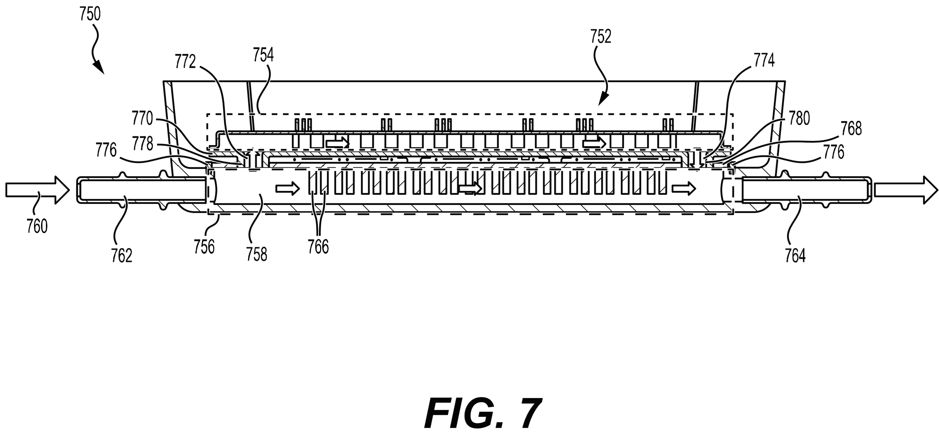

FIG. 7 depicts an exemplary housing assembly, according to one or more embodiments. Housing 750 may house a dual-side power module assembly 752. Specifically, housing 750 may be integrated with dual-side power module assembly 752 to form a dual-side power module cooling system. A first cooling channel (e.g., chamber) 754 and a second cooling channel (e.g., chamber) 756 may be formed from the placement of dual-side power module assembly 752 within housing 750. Second cooling channel 756 may be formed via a housing cavity 758. A coolant 760 may flow (transfer) from an inlet 762, through first cooling channel 754 and/or second cooling channel 756, and out of an outlet 764. Housing 750, in second cooling channel 756, may include one or more fins 766.

Dual-side power module assembly 752 may include a first heatsink plate 768 and a second heatsink plate 770. Second heatsink plate 770 may include an extruded connector 772 at one end and an extruded connector 774 at the opposite end. Similar to the embodiments shown in FIGS. 6A-6F, extruded connector 772 and extruded connector 774 may be laser welded to first heatsink plate 768 via a butt, lap, or edge joint weld. First heatsink plate 768 may be welded to housing 750 via weld 776, or, alternatively, first heatsink plate 768 may be sealed to housing 750 via an O-ring gasket. First heatsink plate 768 may be sealed to housing 750 via adhesive dispensing, laser welding, or friction stir welding. Dual-side power module assembly 752 is therefore sealed all around to housing 750. This seal (e.g., weld 776) between housing 750 and dual-side power module assembly 752 (specifically first heatsink plate 768) facilitates the creation of second cooling channel 756. Coolant 760 may flow through extruded connector 772 into first cooling channel 754 and through extruded connector 774 out of first cooling channel 754.

Extruded connector 772 may be laser welded to a first connector 778 of first heatsink plate 768 and extruded connector 774 may be laser welded to a second connector 780 of first heatsink plate 768. As previously mentioned, one or more fins 766 may be cold forged from first heatsink plate 768 or incorporated into the housing 750 within housing cavity 758 at second cooling channel 756. The integration between housing 750 and dual-side power module assembly 752 to create a cooling system via first cooling channel 754 and second cooling channel 756 may significantly reduce both parts cost and assembly cost.

One or more embodiments may solve the problems of higher costs and extra parts with a dual-side power module assembly that includes laser welding to seal the dual-side cooling system to the power module(s). The dual-side power module assembly may use the housing (e.g., power converter housing) the assembly is assembled to as part of the dual-side cooling path by integrating heatsink fins. One or more embodiments may include a power module assembly that is sealed to a housing of the power converter for a dual-side cooling path. One or more embodiments may use laser welding to seal the interface between the cooling system and the power module(s) to reduce the uneven pressure exerted on the power module(s) due to the rubber seal and spring clamps. Laser welding the interface may reduce the heatsink bowing effect and the associated stress on the power module(s). One or more embodiments may simplify the design and manufacturing process for dual-side power module assemblies by using laser welding to couple a first (e.g., lower) heatsink plate to a second (e.g., upper) heatsink plate.

Other embodiments of the disclosure will be apparent to those skilled in the art from consideration of the specification and practice of the invention disclosed herein. It is intended that the specification and examples be considered as exemplary only, with a true scope of the invention being indicated by the following claims.

## Claims

1. A system comprising a power converter, wherein the power converter includes:
a first power module; and
a cooling module configured to extract heat from the first power module, wherein
the cooling module includes:
a first heatsink plate with a connector; and
a second heatsink plate with an extruded connector,
wherein the extruded connector of the second heatsink plate is laser welded to the connector of the first heatsink plate.

2. The system of claim 1, the power converter further including:
a second power module;
a third power module;
a fourth power module;
a fifth power module; and
a sixth power module, wherein the cooling module is configured to extract heat from the second power module, the third power module, the fourth power module, the fifth power module, and the sixth power module.

3. The system of any one of claims 1 to 2, wherein the first heatsink plate includes fins extending away from a surface of the first heatsink plate.

4. The system of claim any one of claims 1 to 3, wherein the extruded connector is formed by one or more of extrusion, die casting, or machining.

5. The system of claim any one of claims 1 to 4, wherein the laser weld is one or more of a lap joint weld or a butt joint weld.

6. The system of any one of claims 1 to 5, wherein an outer diameter of the extruded connector is smaller than an inner diameter of the connector;
and/or wherein an inner diameter of the extruded connector is the same as an inner diameter of the connector.

7. The system of claim 6, wherein the extruded connector extends to the first heatsink plate such that an end surface of the extruded connector abuts a surface of the first heatsink plate.

8. The system of claim 7, wherein the laser weld extends through the first heatsink plate and the end surface of the extruded connector;
and preferably, wherein the extruded connector is aligned with the connector.

9. The system of any one of claims 1 to 8, wherein the extruded connector extends through the connector such that an outer surface of a sidewall of the extruded connector abuts an inner surface of the connector.

10. The system of claim 9, wherein the outer surface of the sidewall is laser welded to the inner surface of the connector;
and preferably, wherein an end surface of the extruded connector is planar with a surface of the first heatsink plate.

11. The system of any one of claims 1 to 10, wherein the connector of the first heatsink plate is extruded;
and preferably, wherein the extruded connector extends through the connector such that an outer surface of a sidewall of the extruded connector abuts an inner surface of a sidewall of the connector, and wherein an end surface of the extruded connector is planar with an end surface of the connector.

12. The system of any one of claims 1 to 11, wherein the cooling module does not include a gasket seal.

13. A cooling module comprising:
a first heatsink plate including a first connector for a coolant; and
a second heatsink plate including a first extruded connector for the coolant, wherein the first extruded connector of the second heatsink plate is laser welded to the first connector of the first heatsink plate.

14. The cooling module of claim 13, wherein:
the first heatsink plate further includes a second connector for the coolant,
the second heatsink plate further includes a second extruded connector for the coolant, and
the second extruded connector of the second heatsink plate is laser welded to the second connector of the first heatsink plate;
and preferably, wherein the first extruded connector of the second heatsink plate is laser welded to the first connector of the first heatsink plate by one or more of a butt joint laser weld, top lap joint laser weld, side lap joint laser weld, flush edge joint laser weld, recessed edge joint laser weld, or protruding edge joint laser weld.

15. A method comprising:
laser welding a first connector of a first heatsink plate to a first connector of a second heatsink plate,
wherein the first connector of the first heatsink plate and the first connector of the second heatsink plate are configured to transfer coolant from a first coolant chamber to a second coolant chamber.
